# EUROPEAN PATENT APPLICATION

(11) **EP 2 315 234 A1**
(43) Date of publication of application: **27.04.2011**
(21) Application number: 09173541.5
(22) Date of filing: 20.10.2009
(51) Int. Cl.: H01L 21/00, H01L 21/027, H01L 21/02

(54) **Method and installation for producing an anti-reflection and/or passivation coating for semiconductor devices**

(71) Applicant: Applied Materials, Inc., Santa Clara, CA 95054 (US)
(72) Inventor: Auriac, Nicolas, 13450 Grans (FR); Trassl, Roland, 35392 Giessen (DE)
(74) Representative: Zimmermann & Partner

(57) **Abstract**

A method of producing an anti-reflection and/or passivation coating for semiconductor devices is provided. The method includes: providing a semiconductor device precursor 30 having a surface to be provided with the anti-reflection and/or passivation coating; treating the surface with ions; and depositing a hydrogen containing anti-reflection and/or passivation coating onto the treated surface.

## Description

### TECHNICAL FIELD

Embodiments relate to a method and an installation for producing an anti-reflection and/or passivation coating for semiconductor devices, for instance solar cells.

### BACKGROUND ART

Semiconductor devices have many functions in a plurality of industrial fields, including, but not limited to, fabrication of electronic devices, such as transistors, and photovoltaic cells, such as solar cells.

For solar cell production, so called bulk technologies or thin-film technologies may be applied, the former utilizing bulk semiconductor wafers, the latter resulting in thin-film solar cells. The most prevalent bulk material of solar cells is crystalline silicon (c-Si), for instance mono-crystalline silicon (m-Si), or multi-crystalline silicon (mc-Si). A typical material of thin-film solar cells is amorphous and microcrystalline silicon.

A typical solar cell production process based on Si wafers may include for instance some of the following steps: Removal of saw-damage from Si wafers by etching; emitter formation by heat treatment in POCl₃ ambient; removal of resulting phosphorus silicate glass (PSG); deposition of a passivation and/or anti-reflection coating, e.g. by Plasma Enhanced Chemical Vapor Deposition (PECVD); screen printing of rear side metallization and front contact grid lines; and annealing for rear side metal interdiffusion and firing the front contact grid lines.

Crystalline silicon wafers may contain a high density of recombination centers, for instance lattice defects, such as impurities and grain boundaries, and dangling bonds. This results in undesirable recombination of charge carriers, thereby affecting the electrical properties of the solar cell. To improve the properties of solar cells based on Si wafers, a passivation can be performed. For instance, a hydrogenated layer, e.g. a hydrogenated passivation and/or anti-reflection coating, such as SiN:H, can be deposited onto the Si wafer. The hydrogen may diffuse into the bulk of the Si wafer and passivate the recombination centers.

Previous to the deposition of a hydrogenated layer, a clean wafer surface is required, so that the hydrogen incorporated in the layer can effectively diffuse into the bulk material of the wafer for passivation of recombination centers. In a typical solar cell production, the surface is cleaned by means of a chemical solution prior to coating and the wafer is transported in air to the next process. This processing may result in an undesired contamination of the surface, which may affect the passivation of the wafer, and, in addition, requires a high amount of cleaning chemicals.

### SUMMARY

In light of the above, method of producing an anti-reflection and/or passivation coating for semiconductor devices according to claim 1, an installation for producing an anti-reflection and/or passivation coating for semiconductor devices according to claim 9, and a use of an ion source or an ion beam device according to claim 14 are provided.

According to one embodiment, a method of producing an anti-reflection and/or passivation coating for semiconductor devices includes: providing a semiconductor device precursor having a surface to be provided with the anti-reflection and/or passivation coating; treating the surface with ions; and depositing a hydrogen containing anti-reflection and/or passivation coating onto the treated surface.

In a further embodiment, an installation for producing an anti-reflection and/or passivation coating for semiconductor devices includes a chamber; wherein the chamber includes a substrate support, an ion treatment device and a supply of a precursor gas for treatment ions, the ion treatment device being adapted to treat a substrate on the substrate support with the treatment ions, and a coating device adapted to deposit a hydrogen containing anti-reflection and/or passivation coating onto the substrate.

According to a further embodiment, at least one element chosen from an ion source and an ion beam device are used for an inline pre-cleaning process in a method of producing an anti-reflection and/or passivation coating for semiconductor devices.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

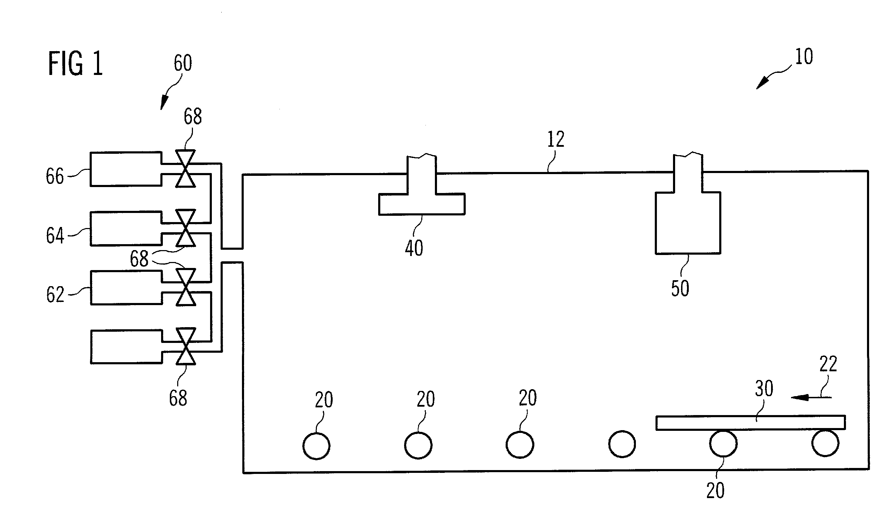

Fig. 1 schematically illustrates an embodiment of an installation for producing an anti-reflection and/or passivation coating for semiconductor devices.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Within the following description of the drawings, the same reference numbers refer to the same components. Generally, only the differences with respect to the individual embodiments are described. It is contemplated that elements of one embodiment may be advantageously utilized in other embodiments without further recitation.

Without limiting the scope, in the following, the semiconductor device will exemplarily be referred to as solar cell. Moreover, without limiting the scope, the substrate of the semiconductor device will exemplarily be referred to as semiconductor device precursor, wafer or silicon wafer (Si wafer), also referred to as a silicon substrate. However, examples of embodiments disclosed herein may also be applied to other types of semiconductor devices, such as thin-film solar cells. Moreover, other semiconductors or semiconductor materials than silicon may be contemplated. Further, without limiting the scope, in the following embodiments, the semiconductor device precursor can be chosen from: a doped semiconductor device precursor, a Si semiconductor device precursor, a doped Si semiconductor device precursor, a Si wafer or a doped Si wafer. For instance, the semiconductor device precursor can be a precursor of a p-n solar cell or a precursor of a solar cell having a reversed p-n structure. In addition, any type of silicon wafer may be used, such as a mono-crystalline silicon wafer and/or an intrinsic silicon wafer, e.g. a substantially pure silicon wafer.

Within embodiments described herein, the hydrogen containing anti-reflection and/or passivation coating can be chosen from: a H doped semiconductor compound layer, a H doped semiconductor nitride layer, and a SiN:H layer.

Without limiting the scope, in the following, embodiments of an installation for producing an anti-reflection and/or passivation coating for semiconductor devices include vacuum-compatible materials and are a vacuum coating installation. Typical applications of embodiments described herein are for example in solar wafer manufacturing and in semiconductor device production.

According to embodiments described herein, a layer of hydrogenated silicon nitride SiN:H, e.g. hydrogenated amorphous silicon nitride (a-SiNx:H), is deposited on the Si wafer. The first purpose of the application of the SiN:H layer is to function as an antireflection coating. Secondly, it provides a surface passivation effect, to reduce the recombination of charge carriers at the surface of silicon wafers in solar cells. Additionally, the hydrogen atoms in the SiN:H layer diffuse into the bulk of the Si wafer and passivate the recombination centers of the crystal lattice. A thermal process can be performed to raise the temperatures of the solar cells for increasing the diffusion of hydrogen atoms to achieve optimum passivation.

According to one embodiment, a method of producing an anti-reflection and/or passivation coating for semiconductor devices includes: providing a semiconductor device precursor having a surface to be provided with the anti-reflection and/or passivation coating; treating the surface with ions; and depositing a hydrogen containing anti-reflection and/or passivation coating onto the treated surface.

In a further embodiment, an installation for producing an anti-reflection and/or passivation coating for semiconductor devices includes a chamber; wherein the chamber includes a substrate support, an ion treatment device and a supply of a precursor gas for treatment ions, the ion treatment device being adapted to treat a substrate on the substrate support with the treatment ions, and a coating device adapted to deposit a hydrogen containing anti-reflection and/or passivation coating onto the substrate.

Embodiments disclosed herein allow for pre-treating the wafer surface with ions before being provided with the anti-reflection and/or passivation coating. Thereby, the wafer surface is prepared, such that the hydrogen incorporated in the coating can effectively diffuse into the surface and/or into the bulk Si material of the Si wafer. The pre-treating can be done in a vacuum installation without breaking the vacuum, enabling an inline pre-treatment of wafers prior to applying the anti-reflection and/or passivation coating. Furthermore, undesired contamination of the surface prior to coating is avoided and the amount of cleaning chemicals is reduced.

According to some embodiments, the ions, also called herein treatment ions, are accelerated towards the surface. The step of treating the surface with the ions can be performed using an ion beam, an ion source and/or an ion beam device. Further, the step of treating the surface with ions may be performed with ions produced from at least one element chosen from an inert gas, an N containing gas, a H containing gas, Ar, N₂, NH₃, H₂, and a F containing gas. The substrate support of the installation may include a transport means for continuously and/or discontinuously transporting one or more substrates through the chamber. The substrates can be plate shaped, and the installation and the transport means may be adapted to transport the substrates horizontally or vertically.

Fig. 1 schematically illustrates an example of the installation for producing an anti-reflection and/or passivation coating for semiconductor devices, according to embodiments. The installation includes a vacuum chamber 10 which can be evacuated by vacuum pumps (not shown). The chamber 10 includes as a substrate support a plurality of transport rolls 20. In operation, one or more substrates 30 can be transported horizontally on the transport rolls 20 through the chamber 10 in a transport direction indicated by arrow 22. For providing and discharging the substrate(s) 30, the chamber 10 has an inlet and an outlet (both not shown), which may e.g. be formed as vacuum slit valves or vacuum load locks.

In the present embodiment, at a top wall 12 of chamber 10, a sputtering device 40 including a solid silicon target is provided as the coating device. The sputtering device may utilize a magnetron system. Further, at the top wall 12, an ion beam source 50 is installed as the ion treatment device. The positions of the sputtering device 40 and the ion beam source 50 are chosen such that, during operation, the substrates 30 can be treated by the ion beam source 50 before being coated using the sputtering device 40. The sputtering device 40 and the ion beam source 50 can each be formed elongated perpendicular to the transport direction 22, such that the substrates 30 may be treated with ions and coated across their whole width.

In a modification of the present embodiment, chamber 10 can further be provided with at least one heating device, such as an IR heater, e.g. for heating the substrate 30 prior to treatment and/or coating.

Chamber 10 further includes a gas supply 60 which is connected to a plurality of gas tanks 62, 64, and 66. In the present embodiment, the gas tanks 66, 64, and 62 are filled with Ar, NH₃, and H₂, respectively. The supply of gas from each gas tank 62, 64, and 66 can be controlled by a process control device (not shown) using a corresponding number of valves 68 installed between the respective gas tank and the chamber 10. The chamber 10 can be further provided with a sensor device (not shown) connected to the process control device, in order to monitor the position of the substrate 30. Thereby, the valves 62, 64, and 66 can be opened and closed in accordance to the position of the substrate 30, in order to provide the specific gas or gases needed for the consecutive process steps of ion treatment and coating. The sputtering device 40 and the ion beam source 50 can also be controlled by the process control device.

According to one embodiment of a method described herein and referring to Fig. 1, a semiconductor device precursor, which is a Si wafer coated with an oxide layer, is provided as the substrate 30. The Si wafer 30 is fed into the chamber 10 shown in Fig. 1, positioned on the transport rolls 20 and conveyed along the transport direction 22. While Si wafer 30 is moved below ion beam source 50, Ar gas is fed into the chamber 10 by opening the valve 68 provided at gas tank 66. This can be accomplished by above mentioned sensor device and process control device. The sensor provides data reflecting the position of the Si wafer 30 while the process control device opens valve 68 and controls the operation of ion beam source 50. Thereby, the surface of wafer 30 facing the ion beam device 50 is bombarded with Ar⁺ ions, the oxide layer is removed and the surface of the Si wafer 30 is cleaned. Thereafter, the Si wafer 30 is moved to a position below the sputtering device 40. Then, the process control device opens the valves 68 at gas tanks 64 and 62 and the sputtering device 40 is operated. Thereby, in addition to Ar, the gases NH₃ and H₂ are introduced into the chamber 10. The Si target included in the sputtering device 40 is sputtered by Ar⁺ and an SiN:H layer is formed on the surface of the Si wafer 30 facing the sputtering device 40. The hydrogen incorporated in the SiN:H layer diffuses into the wafer bulk and passivates recombination centers.

In order to promote the diffusion of the hydrogen into the wafer bulk, the SiN:H coated Si wafer 30 can be heated after having been coated. For instance, in a typical solar cell process, the coated wafers are heated in a so-called firing process where the wafers are exposed to temperatures of about 500°C for about 1 min and to high temperatures, e.g. up to about 900°C, for a few seconds. During this temperature ramp, the contacts for the front and back contacts are formed, and during this step, the hydrogen can diffuse into the bulk of the wafer to passivate dangling bonds and/or lattice defects.

Furthermore, in above embodiment described referring to Fig. 1, the Si wafer 30 may be heated to high temperatures, e.g. to about 400 to 550°C, during the deposition of the SiN:H layer. In some embodiments, the anti-reflection and/or passivation coating may have and/or may be included in a multi-layer structure. In such embodiments, the wafer may be heated to high temperatures, e.g. to about 400 to 500°C, during deposition of a first H-containing layer on the treated wafer. Thereby, diffusion of hydrogen into the bulk wafer is promoted already during deposition.

According to embodiments of the method, during treating the surface with ions, the ions form an ion beam having ion beam energies between a few eV up to about 1.5 keV, e.g. about 2 eV to about 1.5 keV, which may be used at process pressures between a few 10⁻⁵ hPa and a few 10⁻³ hPa, e.g. between about 2x10⁻⁵ hPa and about 7x10⁻³ hPa. Further, according to embodiments of the method, the pressure during a sputtering process performed for depositing the hydrogen containing anti-reflection and/or passivation coating can be in a range of a few 10⁻³ hPa, e.g. about 10⁻³ hPa to about 7x10⁻³ hPa.

A further embodiment of the method of producing an anti-reflection and/or passivation coating for semiconductor devices, which can be combined with any other embodiment described herein, differs from above embodiment in that the supply of Ar gas and of possible other gases, which are used during operation of the ion beam source 50, is stopped and Ar and other residual gases are evacuated from chamber 10 before coating the substrate using the sputtering device 40. Thereby, a clean atmosphere is established for coating. During coating, Ar supply can be resumed.

In another embodiment of the method, which can be combined with any other embodiment described herein, during operation of the ion beam source 50 a gas mixture containing Ar and H₂ gas is introduced into the chamber 10. Thereby, ions formed from Ar and H₂ are accelerated onto the surface of the Si wafer 30, resulting in removal and/or etching of the oxide layer, cleaning of the surface and implantation of H into the Si wafer.

According to a further embodiment, which can be combined with any other embodiment described herein, during operation of the ion beam source 50, ions are formed from Ar gas and N₂ gas to treat the surface of the Si wafer 30. As a result, the oxide layer is partially removed and, in addition, modified by forming an oxynitride layer on the Si wafer 30. In a modification of this embodiment, for operating the ion beam source 50, Ar gas and NH₃ gas are introduced into the chamber 10. Thereby, the oxide layer is removed and/or etched, H is implanted into the Si wafer and a H doped oxynitride layer is formed on the Si wafer 30.

A yet further embodiment, which can be combined with any other embodiment described herein, differs from the above embodiments in that during operation of the ion beam device, the chamber 10 is filled with at least one gas chosen from NH₃ and N₂, and optionally H₂ is also introduced, but no Ar is introduced during ion bombardment. As a result, the oxide layer is removed and/or etched, H is implanted into the Si wafer and a H doped oxynitride layer is formed on the Si wafer 30.

According to other embodiments, which can be combined with any other embodiment described herein, the method described above referring to Fig. 1 is modified in that for operating the ion beam source 50, an F containing gas, e.g. NF₃, is introduced. Thereby, the Si wafer surface is etched, for instance in order to remove a layer of phosphorus silicate glass (PSG).

In some embodiments, which can be combined with any other embodiment described herein, at the beginning of the method, the Si wafer 30 is not coated with an oxide layer. Layers of other materials, e.g. PSG of contaminated SiN, may be present on the Si wafer 30. Hence, the Si wafer surface is cleaned during operation of the ion beam source 50.

According to embodiments, which can be combined with any other embodiment described herein, the coating device may be adapted to form SiN:H by PECVD, instead of forming SiN:H by sputtering. The coating is then performed using a plasma discharge while introducing e.g. SiH₄, H₂ and N₂ and/or NH₃ into the chamber 10.

Further, in some embodiments, which can be combined with any other embodiment described herein, the chamber 10 has two sub-chambers which are vacuum tightly connected to each other, for instance by vacuum slit valves or by a transfer chamber. Each of the two sub-chambers, and optionally the transfer chamber, may be provided with a vacuum pump, such that they can be evacuated individually. In these embodiments, the ion treatment device, e.g. the ion beam device 50, and the coating device, e.g. the sputtering device 40, are positioned in different sub-chambers and may be operated continuously and/or discontinuously while one or more substrates are provided facing the ion treatment device and the coating device consecutively. According to some examples, the installation of embodiments and/or the chamber 10 is a modular coating system.

According to one embodiment, which can be combined with any other embodiment described herein, a method of producing an anti-reflection and/or passivation coating for semiconductor devices includes: providing a semiconductor device precursor having a surface to be provided with the anti-reflection and/or passivation coating; treating the surface with ions; and depositing a hydrogen containing anti-reflection and/or passivation coating onto the treated surface.

In any embodiment described herein, the anti-reflection and/or passivation coating for semiconductor devices can be chosen from: an anti-reflection coating for semiconductor devices, a passivation coating for semiconductor devices, an anti-reflection or passivation coating for semiconductor devices, and an anti-reflection and passivation coating for semiconductor devices.

According to embodiments, which can be combined with any other embodiment described herein, the ions are accelerated towards the surface. Thereby, the ions have enough energy to reach the wafer surface and treat it. For instance, the ions may form an ion beam having ion beam energies between a few eV up to about 1.5 keV, e.g. about 2 eV to about 1.5 keV,

According to embodiments, which can be combined with any other embodiment described herein, the step of treating the surface with ions is performed using an ion beam.

According to embodiments, which can be combined with any other embodiment described herein, the step of treating the surface with ions is performed with ions produced from at least one element chosen from an inert gas, an N containing gas, a H containing gas, Ar, N₂, NH₃, H₂, and a F containing gas.

According to embodiments, which can be combined with any other embodiment described herein, the surface to be provided with the anti-reflection and/or passivation coating is coated with an oxide layer. According to embodiments, which can be combined with any other embodiment described herein, the oxide layer is modified.

According to embodiments, which can be combined with any other embodiment described herein, in the step of treating the surface with ions at least one process is performed chosen from: cleaning the surface, an inline pre-cleaning of the surface, sputtering the surface, sputtering the surface with the ions, removing at least an uppermost atomic or molecular surface layer, removing an oxide layer, etching, a reactive sputter step, forming a nitride, forming an oxynitride, forming a semiconductor nitride, forming a semiconductor compound nitride, forming a semiconductor oxynitride, and implanting hydrogen into the semiconductor device precursor.

According to embodiments, which can be combined with any other embodiment described herein, the method includes at least one step chosen from: heating in a temperature range of about 200° C to about 900°C; heating the semiconductor device precursor to a temperature of at least about 300°C before treating the surface with ions; heating the semiconductor device precursor to a temperature of at least about 400°C after treating the surface with ions; heating the semiconductor device precursor during depositing the hydrogen containing anti-reflection and/or passivation coating onto the treated surface; heating the semiconductor device precursor in a temperature range of about 400° C to about 550°C during depositing the hydrogen containing anti-reflection and/or passivation coating onto the treated surface; heating the semiconductor device precursor after depositing the hydrogen containing anti-reflection and/or passivation coating onto the treated surface; and heating the semiconductor device precursor in a temperature range of about 500° C to about 900°C after depositing the hydrogen containing anti-reflection and/or passivation coating onto the treated surface.

According to embodiments, which can be combined with any other embodiment described herein, the method includes at least one element chosen from: a step wherein the hydrogen containing anti-reflection and/or passivation coating is formed by at least one process chosen from a sputtering process, CVD, and PECVD; a step wherein the depositing of the hydrogen containing anti-reflection and/or passivation coating is performed in a gas atmosphere including at least one element chosen from Ar, a Si containing gas, SiH₄, an N containing gas, N₂, NH₃, a H containing gas and H₂; the semiconductor device precursor being chosen from: a doped semiconductor device precursor, a Si semiconductor device precursor, a doped Si semiconductor device precursor, a Si wafer or a doped Si wafer; and the hydrogen containing anti-reflection or passivation coating being at least one element chosen from: a H doped semiconductor compound layer, a H doped semiconductor nitride layer, and a SiN:H layer.

According to embodiments, which can be combined with any other embodiment described herein, the method is carried out in an inline coating installation.

According to embodiments, which can be combined with any other embodiment described herein, the method is carried out in an inline coating installation during motion of the semiconductor device precursor.

According to embodiments, which can be combined with any other embodiment described herein, the method is at least partially carried out under technical vacuum conditions.

According to embodiments, which can be combined with any other embodiment described herein, the method is completely carried out under technical vacuum conditions.

According to embodiments, which can be combined with any other embodiment described herein, the semiconductor device precursor is continuously and/or discontinuously transported.

According to embodiments, which can be combined with any other embodiment described herein, at least one element chosen from an ion source and/or an ion beam device is used for treating the surface with ions in an inline pre-cleaning process.

In a further embodiment, an installation for producing an anti-reflection and/or passivation coating for semiconductor devices includes a chamber; wherein the chamber includes a substrate support, an ion treatment device and a supply of a precursor gas for treatment ions, the ion treatment device being adapted to treat a substrate on the substrate support with the treatment ions, and a coating device adapted to deposit a hydrogen containing anti-reflection and/or passivation coating onto the substrate. The ion treatment device and the coating device can be provided in different sub-chambers or housings of the chamber.

According to embodiments, which can be combined with any other embodiment described herein, the ion treatment device includes at least one element chosen from an ion source and an ion beam device.

According to embodiments, which can be combined with any other embodiment described herein, the chamber includes a heating device.

According to embodiments, which can be combined with any other embodiment described herein, the coating device includes at least one element chosen from a sputtering device, a CVD device, a PECVD device, and a supply of a precursor gas for the hydrogen containing anti-reflection and/or passivation coating.

According to embodiments, which can be combined with any other embodiment described herein, the precursor gas for the treatment ions includes at least one element chosen from an inert gas, an N containing gas, a H containing gas, Ar, N₂, NH₃, H₂, and a F containing gas.

According to embodiments, which can be combined with any other embodiment described herein, the precursor gas for the hydrogen containing anti-reflection and/or passivation coating includes at least one element chosen from Ar, a Si containing gas, SiH₄, an N containing gas, N₂, NH₃, a H containing gas and H₂.

According to embodiments, which can be combined with any other embodiment described herein, the substrate support includes a transport means for continuously and/or discontinuously transporting one or more substrates through the chamber.

According to embodiments, which can be combined with any other embodiment described herein, the chamber is a vacuum chamber.

According to embodiments, which can be combined with any other embodiment described herein, the chamber includes a single housing or separate modular housings connected to each other.

According to embodiments, which can be combined with any other embodiment described herein, the installation is an inline coating installation.

According to some embodiments, which can be combined with any other embodiment described herein, the surface to be provided with the anti-reflection and/or passivation coating is coated with an oxide layer and/or the oxide layer is modified during treatment with the ions.

According to some embodiments, which can be combined with any other embodiment described herein, the method includes heating the semiconductor device precursor to a temperature above 300 ° C before and/or after treating the surface with ions, equal or above 450 ° C, particularly equal or above 500 ° C.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A method of producing an anti-reflection and/or passivation coating for semiconductor devices, comprising:
providing a semiconductor device precursor having a surface to be provided with the anti-reflection and/or passivation coating;
treating the surface with ions; and
depositing a hydrogen containing anti-reflection and/or passivation coating onto the treated surface.

2. The method of claim 1, wherein the ions are accelerated towards the surface.

3. The method of claim 1 or 2, wherein the step of treating the surface with ions is performed using an ion beam; and/or
wherein the step of treating the surface with ions is performed with ions produced from at least one element chosen from an inert gas, an N containing gas, a H containing gas, Ar, N₂, NH₃, H₂, and a F containing gas.

4. The method of any of the preceding claims, wherein the surface to be provided with the anti-reflection and/or passivation coating is coated with an oxide layer, and/or wherein the oxide layer is modified.

5. The method of any of the preceding claims, wherein in the step of treating the surface with ions at least one process is performed chosen from: cleaning the surface, an inline pre-cleaning of the surface, sputtering the surface, sputtering the surface with the ions, removing at least an uppermost atomic or molecular surface layer, removing an oxide layer, etching, a reactive sputter step, forming a nitride, forming an oxynitride, forming a semiconductor nitride, forming a semiconductor compound nitride, forming a semiconductor oxynitride, and implanting hydrogen into the semiconductor device precursor.

6. The method of any of the preceding claims, comprising at least one step chosen from:
heating in a temperature range of about 200° C to about 900°C;
heating the semiconductor device precursor to a temperature of at least about 300°C before treating the surface with ions;
heating the semiconductor device precursor to a temperature of at least about 400°C after treating the surface with ions;
heating the semiconductor device precursor during depositing the hydrogen containing anti-reflection and/or passivation coating onto the treated surface;
heating the semiconductor device precursor in a temperature range of about 400° C to about 550°C during depositing the hydrogen containing anti-reflection and/or passivation coating onto the treated surface;
heating the semiconductor device precursor after depositing the hydrogen containing anti-reflection and/or passivation coating onto the treated surface; and
heating the semiconductor device precursor in a temperature range of about 500° C to about 900°C after depositing the hydrogen containing anti-reflection and/or passivation coating onto the treated surface.

7. The method of any of the preceding claims,
wherein the hydrogen containing anti-reflection and/or passivation coating is formed by at least one process chosen from a sputtering process, CVD, and PECVD; and/or
wherein the depositing of the hydrogen containing anti-reflection and/or passivation coating is performed in a gas atmosphere comprising at least one element chosen from Ar, a Si containing gas, SiH₄, an N containing gas, N₂, NH₃, a H containing gas and H₂; and/or
wherein the semiconductor device precursor is chosen from: a doped semiconductor device precursor, a Si semiconductor device precursor, a doped Si semiconductor device precursor, a Si wafer or a doped Si wafer; and/or
wherein the hydrogen containing anti-reflection or passivation coating is at least one element chosen from: a H doped semiconductor compound layer, a H doped semiconductor nitride layer, and a SiN:H layer.

8. The method of any of the preceding claims,
wherein the method is carried out in an inline coating installation; and/or wherein the method is carried out in an inline coating installation during motion of the semiconductor device precursor; and/or
wherein the method is at least partially carried out under technical vacuum conditions; and/or
wherein the method is completely carried out under technical vacuum conditions; and/or
wherein the semiconductor device precursor is continuously or discontinuously transported.

9. An installation for producing an anti-reflection and/or passivation coating for semiconductor devices, comprising a chamber;
wherein the chamber comprises
a substrate support,
an ion treatment device and a supply of a precursor gas for treatment ions, the ion treatment device being adapted to treat a substrate on the substrate support with the treatment ions, and
a coating device adapted to deposit a hydrogen containing anti-reflection and/or passivation coating onto the substrate.

10. The installation of claim 9,
wherein the ion treatment device comprises or is an ion source and/or an ion beam device, and/or
wherein the chamber comprises a heating device.

11. The installation of claim 9 or 10, wherein the coating device comprises at least one element chosen from a sputtering device, a CVD device, a PECVD device, and a supply of a precursor gas for the hydrogen containing anti-reflection and/or passivation coating.

12. The installation of any of claims 9 to 11,
wherein the precursor gas for the treatment ions comprises at least one element chosen from an inert gas, an N containing gas, a H containing gas, Ar, N₂, NH₃, H₂, and a F containing gas; and/or
wherein the precursor gas for the hydrogen containing anti-reflection and/or passivation coating comprises at least one element chosen from Ar, a Si containing gas, SiH₄, an N containing gas, N₂, NH₃, a H containing gas and H₂.

13. The installation of any of claims 9 to 12,
wherein the substrate support comprises a transport means for continuously and/or discontinuously transporting one or more substrates through the chamber; and/or
wherein the chamber is a vacuum chamber; and/or
wherein the chamber comprises a single housing or separate modular housings connected to each other; and/or
wherein the installation is an inline coating installation.

14. Use of an ion source or an ion beam device for an inline pre-cleaning process in a method of producing an anti-reflection and/or passivation coating for semiconductor devices.

15. The use of claim 14,
wherein the ion source or ion beam device is used in a method according to any of claims 1 to 8; and/or
wherein the ion source or ion beam device is provided with a precursor gas for ions comprising at least one element chosen from an inert gas, an N containing gas, a H containing gas, Ar, N₂, NH₃, H₂, and a F containing gas.

## Amended claims

### Amended claims in accordance with Rule 137(2) EPC.

**1.** A method of producing an anti-reflection and/or passivation coating for semiconductor devices, comprising:
providing a semiconductor device precursor having a surface to be provided with the anti-reflection and/or passivation coating;
treating the surface with ions; and
depositing a hydrogen containing anti-reflection and/or passivation coating onto the treated surface.

**2.** The method of claim 1, wherein the ions are accelerated towards the surface.

**3.** The method of claim 1 or 2, wherein the step of treating the surface with ions is performed using an ion beam; and/or
wherein the step of treating the surface with ions is performed with ions produced from at least one element chosen from an inert gas, an N containing gas, a H containing gas, Ar, N₂, NH₃, H₂, and a F containing gas.

**4.** The method of any of the preceding claims, wherein the surface to be provided with the anti-reflection and/or passivation coating is coated with an oxide layer, and/or wherein the oxide layer is modified.

**5.** The method of any of the preceding claims, wherein in the step of treating the surface with ions at least one process is performed chosen from: cleaning the surface, an inline pre-cleaning of the surface, sputtering the surface, sputtering the surface with the ions, removing at least an uppermost atomic or molecular surface layer, removing an oxide layer, etching, a reactive sputter step, forming a nitride, forming an oxynitride, forming a semiconductor nitride, forming a semiconductor compound nitride, forming a semiconductor oxynitride, and implanting hydrogen into the semiconductor device precursor.

**6.** The method of any of the preceding claims, comprising at least one step chosen from:
heating in a temperature range of about 200° C to about 900°C;
heating the semiconductor device precursor to a temperature of at least about 300°C before treating the surface with ions;
heating the semiconductor device precursor to a temperature of at least about 400°C after treating the surface with ions;
heating the semiconductor device precursor during depositing the hydrogen containing anti-reflection and/or passivation coating onto the treated surface;
heating the semiconductor device precursor in a temperature range of about 400° C to about 550°C during depositing the hydrogen containing anti-reflection and/or passivation coating onto the treated surface;
heating the semiconductor device precursor after depositing the hydrogen containing anti-reflection and/or passivation coating onto the treated surface;
and
heating the semiconductor device precursor in a temperature range of about 500° C to about 900°C after depositing the hydrogen containing anti-reflection and/or passivation coating onto the treated surface.

**7.** The method of any of the preceding claims,
wherein the hydrogen containing anti-reflection and/or passivation coating is formed by at least one process chosen from a sputtering process, CVD, and PECVD; and/or
wherein the depositing of the hydrogen containing anti-reflection and/or passivation coating is performed in a gas atmosphere comprising at least one element chosen from Ar, a Si containing gas, SiH₄, an N containing gas, N₂, NH₃, a H containing gas and H₂; and/or
wherein the semiconductor device precursor is chosen from: a doped semiconductor device precursor, a Si semiconductor device precursor, a doped Si semiconductor device precursor, a Si wafer or a doped Si wafer; and/or wherein the hydrogen containing anti-reflection or passivation coating is at least one element chosen from: a H doped semiconductor compound layer, a H doped semiconductor nitride layer, and a SiN:H layer.

**8.** The method of any of the preceding claims,
wherein the method is carried out in an inline coating installation; and/or
wherein the method is carried out in an inline coating installation during motion of the semiconductor device precursor; and/or
wherein the method is at least partially carried out under technical vacuum conditions; and/or
wherein the method is completely carried out under technical vacuum conditions; and/or
wherein the semiconductor device precursor is continuously or discontinuously transported.

**9.** An installation for producing an anti-reflection and/or passivation coating for semiconductor devices, comprising a chamber;
wherein the chamber comprises
a substrate support, -
an ion treatment device and a supply of a precursor gas for treatment ions, the ion treatment device being adapted to treat a substrate on the substrate support with the treatment ions,
a coating device adapted to deposit a hydrogen containing anti-reflection and/or passivation coating onto the substrate,
wherein the ion treatment device comprises or is an ion source and/or an ion beam device, and
a supply of a precursor gas for the hydrogen containing anti-reflection and/or passivation coating.

**10.** The installation of claim 9, wherein the chamber comprises a heating device.

**11.** The installation of claim 9 or 10, wherein the coating device comprises at least one element chosen from a sputtering device, a CVD device, and a PECVD device.

**12.** The installation of any of claims 9 to 11,
wherein the precursor gas for the treatment ions comprises at least one element chosen from an inert gas, an N containing gas, a H containing gas, Ar, N₂, NH₃, H₂, and a F containing gas; and/or
wherein the precursor gas for the hydrogen containing anti-reflection and/or
passivation coating comprises at least one element chosen from Ar, a Si containing gas, SiH₄, an N containing gas, N₂, NH₃, a H containing gas and H₂.

**13.** The installation of any of claims 9 to 12,
wherein the substrate support comprises a transport means for continuously and/or discontinuously transporting one or more substrates through the chamber; and/or
wherein the chamber is a vacuum chamber; and/or
wherein the chamber comprises a single housing or separate modular housings connected to each other; and/or
wherein the installation is an inline coating installation.

**14.** Use of an ion source or an ion beam device for an inline pre-cleaning process in a method of producing an anti-reflection and/or passivation coating for semiconductor devices.

**15.** The use of claim 14,
wherein the ion source or ion beam device is used in a method according to any of claims 1 to 8; and/or
wherein the ion source or ion beam device is provided with a precursor gas for ions comprising at least one element chosen from an inert gas, an N containing gas, a H containing gas, Ar, N₂, NH₃, H₂, and a F containing gas.
